# DEMANDE DE BREVET EUROPEEN

(11) **EP 4 503 138 A1**
(43) Date de publication de la demande: **05.02.2025**
(21) Numéro de dépôt: 24192253.3
(22) Date de dépôt: 01.08.2024
(51) Int. Cl.: H01L 29/778, H01L 23/29, H01L 23/31, H01L 29/423, H01L 21/56, H01L 29/20

(54) **PROCÉDÉ DE RÉALISATION D'UN TRANSISTOR À EFFET DE CHAMP À HAUTE MOBILITÉ**

(30) Priorité: 03.08.2023 FR 2308410
(71) Demandeur: THALES, 92190 Meudon (FR); Commissariat à l'Energie Atomique et aux Energies Alternatives, 75015 Paris (FR)
(72) Inventeur: JACQUET, Jean-Claude, 91400 ORSAY (FR); PATARD, Olivier, 78000 VERSAILLES (FR); DELAGE, Sylvain, 92098 PARIS LA DEFENSE (FR); PIOTROWICZ, Stéphane, 78114 MAGNY LES HAMEAUX (FR); AUBRY, Raphaël, 91440 BURES SUR YVETTE (FR)
(74) Mandataire: Atout PI Laplace

(57) **Abrégé**

L'invention concerne un procédé de réalisation d'un transistor à effet de champ à haute mobilité comprenant :
- une étape de réalisation d'un empilement (10) selon un axe z déposé sur un substrat (11),
- une étape de réalisation d'un drain (D), d'une source (S), et d'une grille (G),
la face supérieure (14) de la couche barrière entre la source et le drain présentant une première zone (Z1) localisée à partir du pied de grille et de part et d'autre de la grille sur une distance d'au plus 100 nm, et une deuxième zone (Z2) localisée sur la partie restante de la face supérieure,
- une étape de dépôt d'une première couche de passivation (PLhi) présentant une constante diélectrique (εₕᵢ) supérieure ou égale à 15, ledit dépôt étant réalisé de sorte que la première couche de passivation s'étende sur au moins la première zone (Z1),
- une étape de dépôt d'une deuxième couche de passivation (PLlow) présentant une constante diélectrique (ε_{low}) inférieure ou égale à 10, ledit dépôt étant réalisé de sorte que la deuxième couche de passivation s'étende sur au moins la deuxième zone (Z2),
- l'étape de dépôt de la première couche de passivation comprenant une sous-étape de gravure au travers dudit chapeau de grille, la première couche de passivation (PLhi) étant alors délimitée par la projection selon Z dudit chapeau.

## Description

### DOMAINE DE L'INVENTION

La présente invention se situe dans le domaine des transistors à effet de champ à haute mobilité électronique dénommés transistors HEMT (acronyme de l'expression anglo-saxonne « High Electron Mobility Transistor ») en technologie GaN et pour des applications hyperfréquences, typiquement à des fréquences allant jusqu'à 40 GHz, voire 80 GHz dans un proche avenir.

Plus particulièrement l'invention concerne la passivation des transistors au voisinage de la grille.

### ETAT DE LA TECHNIQUE

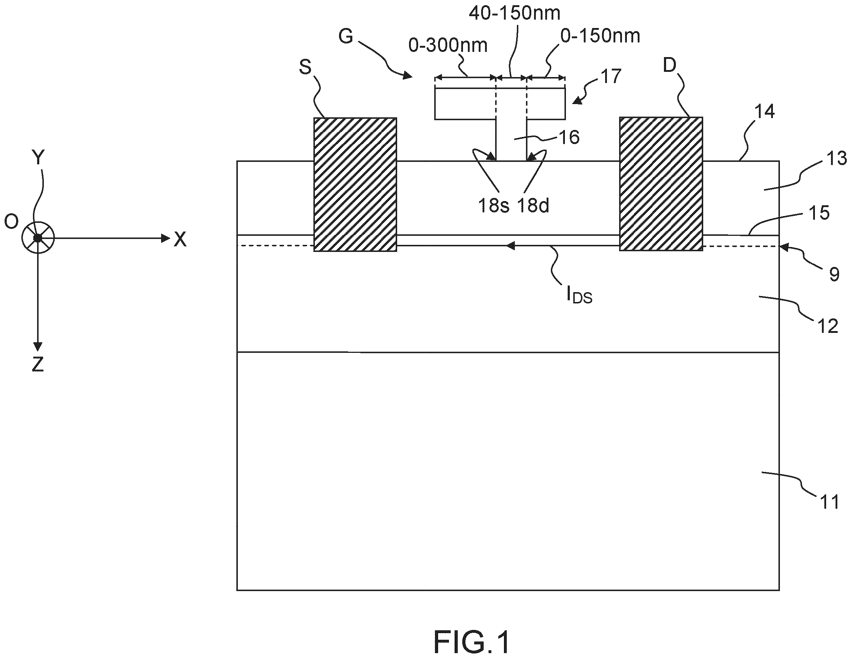

La figure 1 représente schématiquement une coupe de la structure d'un système de transistor HEMT élémentaire classique, dans un plan Oxz, réalisé sur un substrat 11. Classiquement on utilise un substrat 11 isolant ou semi-conducteur, par exemple comprenant du silicium (Si), du Carbure de Silicum (SiC) ou du Saphire (Al₂O₃), sur lequel est réalisé un empilement selon l'axe z d'au moins deux couches de semi-conducteur qui s'étendent dans le plan Oxy.

Une première couche 12, dénommée couche tampon, ou « buffer » (terme utilisé dans la littérature anglo-saxonne), présente une large bande interdite (matériau semi-conducteur dit à grand gap) par exemple comprenant un matériau composé binaire de l'azote, tel le GaN ou un matériau à base de composé ternaire de nitrure d'éléments III, dénommé III-N, tel que l'AIGaN, ou plus précisément l'AlₓGa₁₋ₓN.

Une seconde couche, dénommée couche barrière 13, présente une bande interdite plus grande que celle de la couche tampon 12. Cette couche comprend un matériau à base de composé quaternaire, ternaire ou binaire de nitrure d'éléments III, dénommé III-N, à base de AI, Ga, In ou B.

Par exemple, avec une couche tampon en GaN, la couche barrière comprend de l'AlₓGa₁₋ₓN ou de l'In₁₋ₓAlₓN, ou une séquence In₁₋ₓAlₓN/AlN ou AlₓGa₁₋ₓN/AlN. L'épaisseur de la couche barrière 13 est typiquement comprise entre 5 nm et 40 nm, l'épaisseur de la couche tampon 12 est typiquement comprise entre 0.2 µm et 3 µm. La couche tampon 12 et la couche barrière 13 sont classiquement réalisées par épitaxie par MOCVD ou par MBE. A titre d'exemple, on peut citer une couche tampon à base de GaN avec une couche barrière à base d'AlGaN ou d'InAIN, et plus précisément à base d'AlₓGa₁₋ₓN ou d'In_{z}Al_{1-z}N, avec x compris typiquement entre 15% et 35% et z compris typiquement entre 15% et 25%.

Des couches supplémentaires peuvent être présentes soit en surface, soit entre la couche tampon et la couche barrière.

La jonction entre la couche tampon et la couche barrière constitue une hétérojonction 15 qui s'étend également dans le plan Oxy. L'origine O du repère Oxyz est choisie dans ce plan.

Un transistor HEMT comprend classiquement une source S, un drain D et une grille G déposés sur la face supérieure 14 de la couche barrière 13. La grille G est déposée entre la source S et le drain D et permet de commander le transistor. Typiquement la distance grille-source d_{GS} est comprise entre 0.4 et 1 µm et la distance grille-drain d_{GD} est comprise entre 0.6 à 2 µm. Préférentiellement la grille G présente une forme en T ou en Γ, et est constituée d'un tronc 16 surmonté d'au moins un chapeau 17 (il peut y en avoir plusieurs l'un sur l'autre). Les deux branches du chapeau ne sont pas nécessairement symétriques, et la branche côté drain peut même être inexistante (grille dite en Γ). La base du tronc 16 en contact avec la couche barrière 13 est couramment dénommée pied de grille, la référence 18s correspondant au pied de grille côté source et la référence 18d correspondant au pied de grille côté drain sur la figure 1.

La conductance entre la source S et le drain D est modulée par l'action électrostatique de la grille G, classiquement de type Schottky ou de type MIS pour (métal/isolant/semiconducteur), et la tension V_{GS} appliquée entre la grille et la source commande le transistor.

Un gaz bidimensionnel d'électrons 9 (dénommé 2DEG pour « two-Dimensional Electron Gas ») est localisé au voisinage de l'hétérojonction 15. Ces électrons sont mobiles dans le plan Oxy et ont une forte mobilité électronique µe, typiquement supérieure à 1000cm²/Vs. Dans un fonctionnement normal du transistor ces électrons ne peuvent pas circuler dans la direction z car ils sont confinés dans le puits de potentiel se formant dans le plan Oxy au voisinage de l'hétérojonction 15. Le gaz d'électrons 9, confiné dans ce qui est dénommé le canal du transistor, est donc apte à transporter un courant I_{DS} circulant entre le drain et la source. Classiquement, une différence de potentiel V_{DS} est appliquée entre la source S et le drain D, avec typiquement une source S à la masse, et la valeur du courant I_{DS} est une fonction de la tension appliquée V_{GS} entre la grille G et la source S.

L'effet transistor est basé sur la modulation de la conductance gm entre les contacts S et D par l'action électrostatique de l'électrode de commande G. La variation de cette conductance est proportionnelle au nombre de porteurs libres dans le canal, et donc au courant entre source et drain. C'est l'effet d'amplification transistor qui permet de transformer un faible signal appliqué sur la grille en un signal plus fort récupéré sur le drain.

Pour que les composants en technologies GaN puissent fonctionner aux fréquences millimétriques (> 20 GHz) avec des performances suffisantes, il est nécessaire de modifier un certain nombre de paramètres définissant le transistor. Parmi ces modifications, celles ayant une importance de premier ordre sont :

La réduction de l'épaisseur de la barrière 13 qui en rapprochant la grille du canal d'électrons permet d'améliorer le gain du transistor.

L'augmentation du nombre de porteurs dans les structures pour réduire les résistances d'accès.

La diminution de la longueur de grille des transistors qui permet de réduire le temps de transit des électrons sous la grille. Cette dernière option peut nécessiter une optimisation de la couche tampon 12 afin de conserver un bon confinement des électrons dans le canal.

Cependant, certaines de ses modifications, notamment l'augmentation de la densité de porteurs dans le canal ns et la réduction de l'épaisseur de la barrière 13, contribuent à augmenter la valeur du champ électrique dans la structure lorsque le transistor est en fonctionnement. Cette augmentation du champ électrique est particulièrement prononcée pour les filières de transistor InAI(Ga)N/GaN ou AIN pour lesquelles la densité d'électrons dans le canal ns se situe dans la fourchette 1.2x10¹³/cm² à 2×10¹³/cm². Cela se traduit par une robustesse réduite de cette filière.

Le champ électrique particulièrement intense dans ces matériaux peut localement atteindre une intensité supérieure à 10 MV/cm. Le maximum de champ électrique est localisé au pied de la grille, typiquement dans l'espace grille-drain.

Du fait de l'absence de substrats GaN de grandes dimensions (supérieures à 3"), il est nécessaire de réaliser la croissance des matériaux semi-conducteurs sur des substrats hôtes tels que l'Al₂O₃, le SiC ou le silicium. Ces derniers possèdent cependant un paramètre de maille différent de celui du GaN ce qui engendre une importante densité de défauts orientés perpendiculairement au courant circulant dans le canal.

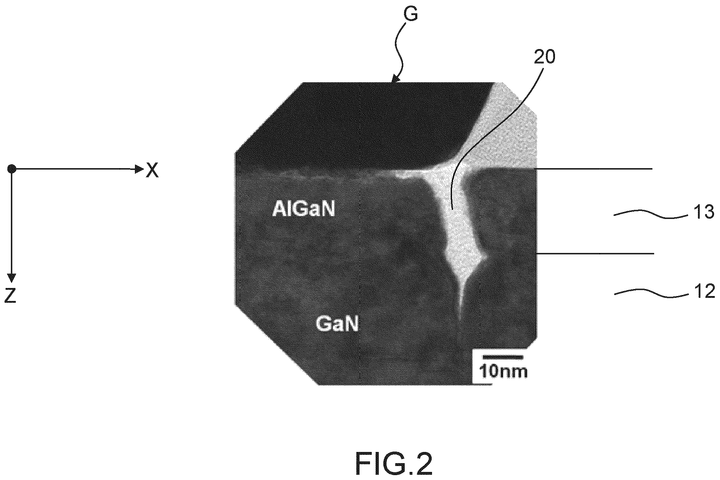

Ces défauts traversent toute la structure et la densité typique de défauts émergents en surface est de l'ordre de quelques 10⁸ à quelques 10⁹/cm². La figure 2 illustre une de ces dislocations 20 localisée au pied de la grille dans un plan en coupe xz. Ces défauts constituent des points de fragilité du transistor qui, sous l'action d'un champ électrique élevé et des contraintes induites par effet piézoélectrique inverse, vont être à l'origine d'une dégradation des performances (augmentation du courant de grille notamment) voire même d'une défaillance des composants. Cette zone de champ électrique intense a été identifiée dans la littérature comme impactant la fiabilité des dispositifs (voir par exemple la publication «Correlation between Physical Defects and Performance in AIGaN/GaN High Electron Mobility Transistor Devices », DOI: 10.4313/TEEM.2010.11.2.049).

Le champ électrique dans la structure étant proportionnel aux tensions appliquées au transistor, une solution serait de réduire celles-ci, notamment la tension de drain Vds. Cela se ferait cependant au détriment du rendement en puissance ajoutée (PAE) et de la puissance disponible en sortie du transistor.

Par ailleurs selon l'état de l'art on recouvre la face 14 d'une couche de diélectrique, dénommée couche de passivation, car la face supérieure 14 de la couche barrière 13 doit être protégée des contacts avec l'extérieur pour protéger la surface des agressions extérieures (humidité, impuretés) et pour stabiliser/neutraliser les états de surface présents à la surface du semiconducteur. Classiquement les matériaux diélectriques utilisés sont : Al₂O₃, Si₃N₄, SiO₂, SiOₓN_{y} ou AIN. Ils présentent des constantes diélectriques comprises entre 3.7 (SiO₂) et 10 (Al₂O₃).

Le document US9099433 décrit un transistor HEMT avec une grille en T comprenant deux couches de passivation. Une première couche de passivation est déposée sur la surface 14 entre la grille et la source et entre la grille et le drain, et a une fonction classique de passivation. Une deuxième couche de passivation enrobe la grille et recouvre la première couche.

Le brevet US9099433 propose une solution pour optimiser les performances RF en réduisant les capacités Cgd et Cgs sans dégrader les courants de fuites et les performances électriques en mode pulsé (drain lag et gate lag) qui sont liés au champ électrique.

Pour réduire les capacités Cgd et Cgs les branches du T de la grille sont éloignées de la surface du composant. Ce faisant le champ électrique au sein du transistor augmente ce qui entraine une augmentation des courants de fuites et une dégradation des performances électriques en mode pulsé.

Pour conserver l'effet sur le champ électrique des capacités Cgd et Cgs tout en ne dégradant pas (ou à minima) les performances RF on dépose localement, au plus près du pied de grille, là où le champ électrique est le plus intense, un matériau diélectrique. On ajoute ainsi localement des capacités MIS suffisamment petites par rapport à Cgd et Cgs. Cette approche permet de conserver l'effet de réduction sur le champ électrique tout en limitant l'impact sur les capacités Cgd et Cgs et donc sur les performances RF. Cette deuxième couche est réalisée dans un matériau diélectrique usuel tel que listé ci-dessus.

Cette deuxième couche permet de résoudre en partie le problème de champ électrique élevé mais est d'une efficacité limitée par le choix de matériaux diélectriques de constantes diélectriques qui ne doivent pas être trop élevées (<= à 10), car présentes sur tout le transistor, pour ne pas dégrader les performances RF.

L'invention vise à surmonter au moins l'un des inconvénients précités en proposant un transistor HEMT présentant deux couches de passivation configurées de manière à réduire la valeur du champ électrique en pied de grille.

### DESCRIPTION DE L'INVENTION

La présente invention a pour objet un procédé de réalisation d'un transistor à effet de champ à haute mobilité comprenant :
- une étape de réalisation d'un empilement selon un axe z déposé sur un substrat, l'empilement comprenant :
   ∘ une couche tampon comprenant un premier matériau semi-conducteur comprenant un composé binaire ou ternaire ou quaternaire de nitrure et présentant une première bande interdite,
   ∘ une couche barrière comprenant un deuxième matériau semi-conducteur comprenant un composé binaire ou ternaire ou quaternaire de nitrure et présentant une deuxième bande interdite, la deuxième bande interdite étant supérieure à la première bande interdite,
   ∘ une hétérojonction entre ladite couche tampon et ladite couche barrière et,
   ∘ un gaz bidimensionnel d'électrons localisé dans un plan xy perpendiculaire à l'axe z et au voisinage de l'hétérojonction, puis
- une étape de réalisation d'un drain, d'une source, et d'une grille disposée sur une face supérieure de ladite couche barrière entre la source et le drain, et de sorte que la grille présente une forme comprenant un tronc surplombé d'au moins un chapeau, une base du tronc en contact avec ladite couche barrière étant dénommée pied de grille,
- la face supérieure de la couche barrière entre la source et le drain présentant une première zone localisée à partir du pied de grille et de part et d'autre de la grille sur une distance d'au plus 100 nm, et une deuxième zone localisée sur la partie restante de la face supérieure,
- une étape de dépôt d'une première couche de passivation présentant une constante diélectrique supérieure ou égale à 15, ledit dépôt étant réalisé de sorte que la première couche de passivation s'étende sur au moins la première zone, la première couche de passivation étant en contact direct avec la couche barrière uniquement sur la première zone,
- une étape de dépôt d'une deuxième couche de passivation présentant une constante diélectrique inférieure ou égale à 10, ledit dépôt étant réalisé de sorte que la deuxième couche de passivation s'étende sur au moins la deuxième zone, la deuxième couche de passivation étant en contact direct avec la couche barrière uniquement sur la deuxième zone,
- l'étape de dépôt de la première couche de passivation comprenant une sous-étape de gravure au travers dudit chapeau de grille, la première couche de passivation étant alors délimitée par la projection selon Z dudit chapeau.

Selon un mode de réalisation l'étape de dépôt de la première couche de passivation a lieu avant l'étape de dépôt de la deuxième couche de passivation, ladite deuxième couche de passivation recouvrant alors au moins partiellement la première couche de passivation.

Selon un mode de réalisation l'étape de dépôt de la deuxième couche de passivation a lieu avant l'étape de dépôt de la première couche de passivation, ladite première couche de passivation recouvrant alors partiellement la deuxième couche de passivation.

La description suivante présente plusieurs exemples de réalisation du dispositif de l'invention. Ces exemples sont non limitatifs de la portée de l'invention. Ces exemples de réalisation présentent à la fois les caractéristiques essentielles de l'invention ainsi que des caractéristiques additionnelles liées aux modes de réalisation considérés.

L'invention sera mieux comprise et d'autres caractéristiques, buts et avantages de celle-ci apparaîtront au cours de la description détaillée qui va suivre et en regard des dessins annexés donnés à titre d'exemples non limitatifs et sur lesquels :
La figure 1 déjà citée illustre un transistor à effet de champ à haute mobilité selon l'état de la technique.
La figure 2 déjà citée illustre une dislocation localisée au pied de la grille.
La figure 3 illustre un transistor HEMT issu du procédé selon l'invention dans laquelle la première couche de passivation est déposée en premier.
La figure 4 illustre la deuxième variante d'un transistor HEMT issu du procédé selon l'invention dans laquelle la deuxième couche de passivation est déposée en premier.
La figure 5 illustre un mode de réalisation d'un transistor HEMT issu du procédé selon l'invention pour lequel la première couche de passivation enrobe toute la grille.
La figure 6 illustre un mode de réalisation de la première variante d'un transistor HEMT issu du procédé selon l'invention pour lequel la première couche de passivation est délimitée par la projection selon Z du chapeau de grille.
La figure 7 illustre un mode de réalisation de la deuxième variante d'un transistor HEMT issu du procédé selon l'invention pour lequel la première couche de passivation est délimitée par la projection selon Z du chapeau de grille.
La figure 8a illustre la première variante d'un transistor issu du procédé selon l'invention avec l'option d'une première couche de passivation qui enrobe toute la grille et qui est déposée en utilisant le chapeau de grille comme masque.
La figure 8b illustre la deuxième variante d'un transistor issu du procédé selon l'invention avec l'option d'une première couche de passivation qui enrobe toute la grille et qui est déposée en utilisant le chapeau de grille comme masque.
La figure 8c illustre les différents champs électriques d'intérêt au voisinage du pied de grille pour la configuration de la figure 8b.
La figure 9 illustre la valeur du champ électrique Fz(B) en fonction de x pour trois valeurs différentes 7, 15 et 30 de la constante diélectrique de la première couche de passivation.
La figure 10 illustre la valeur du champ électrique Fx(ch) en fonction de x pour trois valeurs différentes 7, 15 et 30 de la constante diélectrique de la première couche de passivation.
La figure 11 illustre la valeur du module du champ électrique |F(D)| en fonction de x pour trois valeurs différentes 7, 15 et 30 de la constante diélectrique de la première couche de passivation.
La figure 12 illustre le gain d'un transistor selon l'invention en fonction de la fréquence d'utilisation pour un dépôt de la première couche de passivation localisé sur toute la surface, à 100 nm de part et d'autre de la grille ou à 25 nm de part et d'autre de la grille.

### DESCRIPTION DETAILLEE DE L'INVENTION

L'invention concerne un procédé pour réaliser un transistor HEMT 10 présentant un empilement, une grille, une source et un drain telle que décrit figure 1.

Un exemple de dimensionnement de la grille pour une application haute fréquence (fréquence d'utilisation supérieure à 10 GHz, typiquement comprise entre 10 et 80 GHz) est un tronc 16 de largeur comprise entre 40 et 250 nm, une branche côté drain de dimension Bd comprise entre 0 et 150 nm, et une branche côté source de dimension Bs comprise entre 0 et 300 nm.

On dénomme d_{GS} la distance entre la grille et la source et d_{GD} la distance entre la grille et le drain. Pour une application haute fréquence on a typiquement d_{GS} compris entre 0.5 et 2 µm et d_{GD} typiquement compris entre 1 et 4 µm.

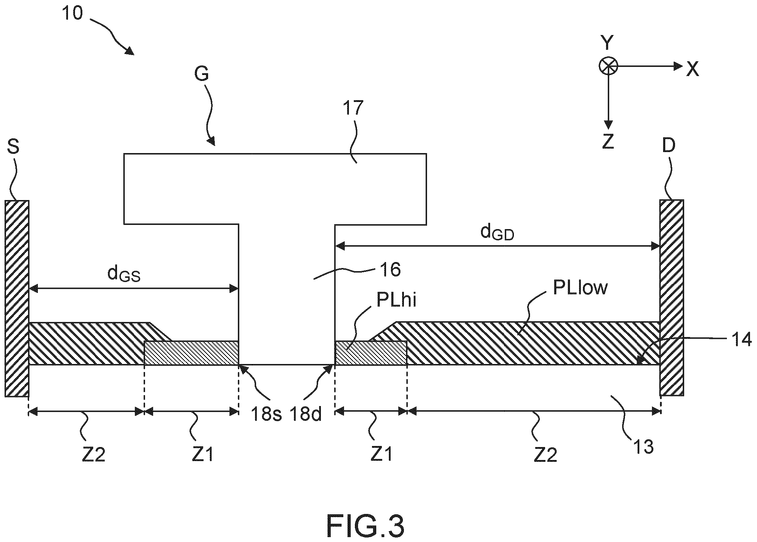

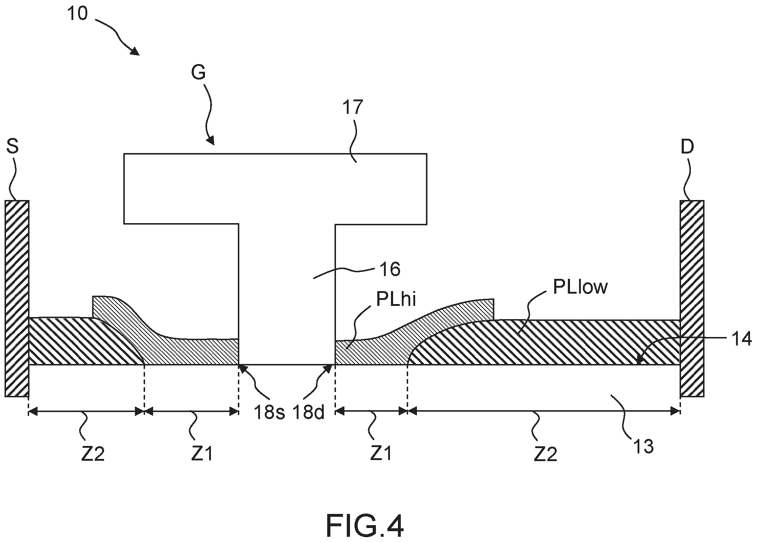

La spécificité du HEMT 10 issu du procédé selon l'invention est qu'il présente un agencement particulier de deux couches de passivation PLhi et PLlow tel qu'illustré figures 3 et 4, la couche de passivation PLhi présentant une caractéristique spécifique comme expliqué plus loin.

Pour des applications hautes fréquences (typiquement > 20 GHz), la couche barrière 13 comprend un matériau choisi parmi : InAIN, AIGaN, InAIGaN, AIN. Ces différents matériaux sont classiquement utilisés actuellement pour la réalisation de composant GaN à hautes fréquences.

On décompose la surface supérieure 14 de la couche barrière 13 entre la source S et le drain D en une première zone Z1 localisée à partir du pied de grille 18s, 18d, et de part et d'autre de la grille G sur une distance d'au plus 100 nm de chaque côté du pied de grille, et une deuxième zone Z2 localisée sur la partie restante de la face supérieure 14 entre la grille et la source et entre la grille et le drain.

Le transistor 10 issu du procédé selon l'invention comprend une première couche de passivation PLhi qui présente une constante diélectrique εₕᵢ supérieure ou égale à 15. Cette valeur élevée de la constante diélectrique est contre-intuitive comme expliqué plus loin. La partie de PLhi en contact direct avec la face supérieure s'étend uniquement sur la zone Z1. La zone Z1 du côté source n'est pas nécessairement de la même dimension que la zone Z1 du côté drain.

Le transistor 10 comprend également une deuxième couche de passivation PLlow présentant une constante diélectrique ε_{low} inférieure ou égale à 10. La partie de PLlow en contact direct avec la couche barrière s'étend uniquement sur la deuxième zone Z2. Cette deuxième couche de passivation présente une épaisseur standard (typiquement 10-50 nm), et une constante diélectrique inférieure à 10 correspond au cas d'une couche de passivation usuelle dans ce type de transistor.

La couche barrière 13 est ainsi en contact direct avec une couche de passivation PLhi à forte constante diélectrique au pied de la grille (sur au plus 100 nm) et en contact direct avec une couche de passivation PLlow à faible constante diélectrique sur le reste de sa surface.

La technologie de fabrication permet deux agencements constituant deux variantes du transistor 10 issu du procédé selon l'invention.

La figure 3 illustre la première variante dans laquelle la couche PLhi est déposée en premier. La partie de couche PLhi en contact avec la face 14 (zone Z1) constitue alors l'intégralité de la couche PLhi s'étendant selon le plan xy. La couche PLlow déposée après la couche PLhi présente une partie en contact avec la face 14 s'étendant sur la région Z2 et une partie qui recouvre au moins partiellement la première couche de passivation PLhi. Le fait que la couche PLlow s'étende jusqu'au pied de grille (par-dessus PLhi) ou pas dépend de la technologie de fabrication. Typiquement le chapeau de la grille crée un ombrage lors du dépôt, et la couche PLlow diminue en épaisseur à partir de la projection selon z du chapeau, tel qu'illustré figures 3 et 4. On dénomme d_{GS} la distance entre la grille et la source et d_{GD} la distance entre la grille et le drain.

La figure 4 illustre la deuxième variante dans laquelle la couche PLlow est déposée en premier. La couche PLlow est déposée de manière à laisser une zone Z1 sans couche. La partie de couche PLlow en contact avec la face 14 (zone Z2) constitue alors l'intégralité de la couche PLlow s'étendant selon le plan xy. La couche PLhi, déposée après PLlow, présente une partie en contact avec la face 14 qui s'étend selon Z1 et une autre partie qui recouvre au moins partiellement la couche PLlow.

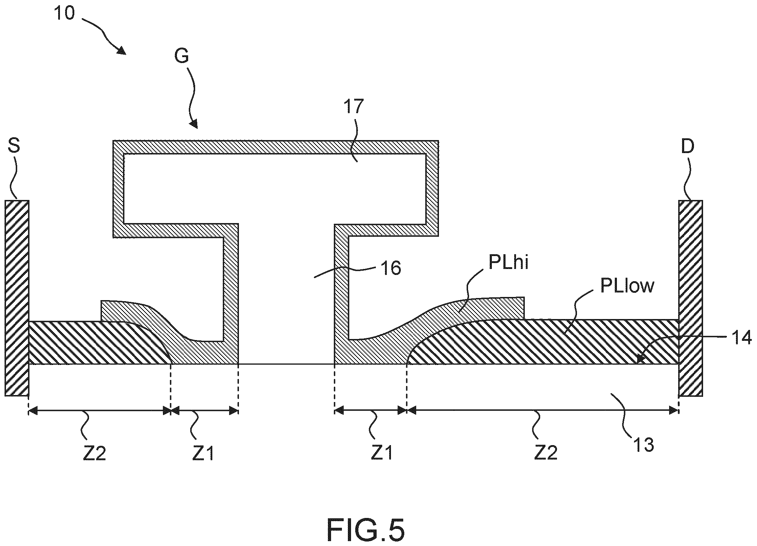

En fonction de la technologie de dépôt de la couche PLhi, la première couche de passivation peut selon une première option recouvrir le tronc 16 de la grille G, ou selon une deuxième option enrober toute la grille, tel qu'illustré figure 5. Ces options sont bien entendu compatibles avec toutes les variantes et modes de réalisation précités.

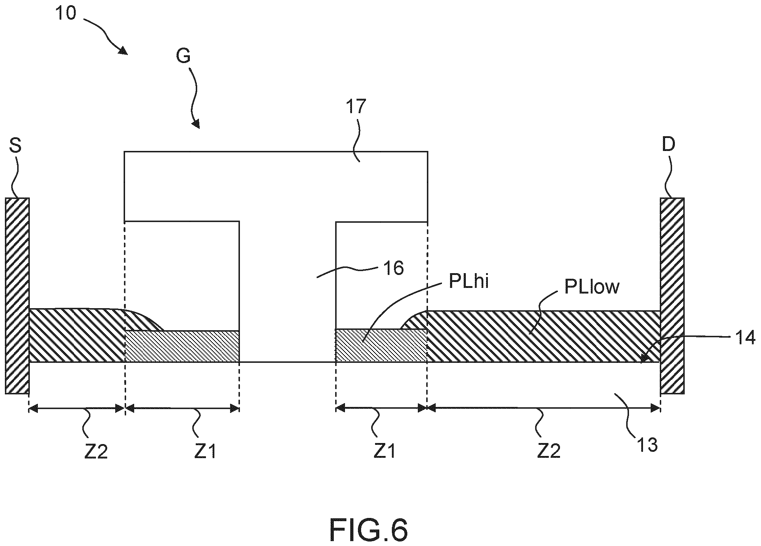

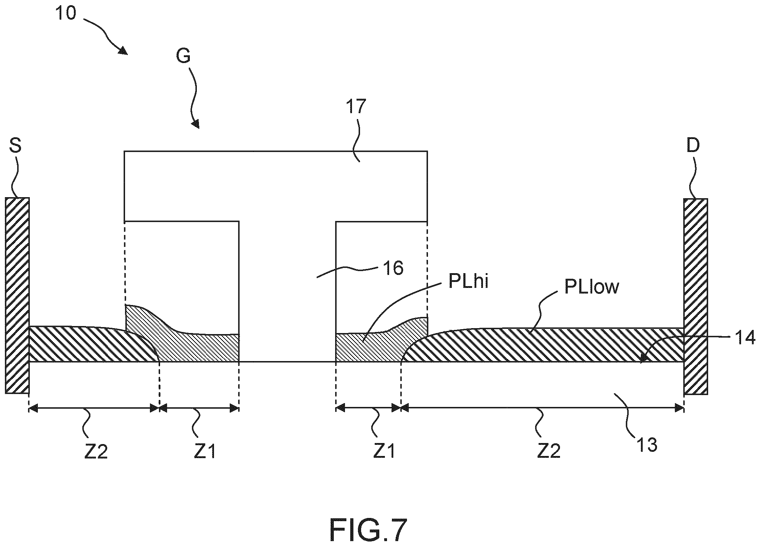

Selon un mode de réalisation qui présente des facilités de mise en oeuvre technologique, l'étendue de la première couche de passivation PLhi est délimitée par la projection selon Z du chapeau de grille 17, tel qu'illustré figure 6 pour la première variante et figure 7 pour la deuxième variante.

A l'aide de nombreuses simulations et expériences les inventeurs ont démontré que l'utilisation d'une couche de passivation PLhi avec une constante diélectrique élevée par rapport à l'utilisation d'une couche de constante diélectrique plus faible, par exemple 7 pour une couche de Si₃N₄, permet de fortement réduire le champ électrique au voisinage du pied de grille (voir plus loin). L'effet de réduction est particulièrement notable lorsque εₕᵢ est supérieur ou égal à 15. Typiquement εₕᵢ est dans la gamme 15-200. La diminution du champ électrique au pied de grille permet de relaxer les contraintes mécaniques induites par effet piézoélectrique inverse à des valeurs acceptables pour les tensions de fonctionnement visées. Un exemple de ces tensions est : Vds_max = 40 V et Vgs_max = -9V

Afin de ne pas dégrader le gain en puissance du transistor la couche PLhi est localisée au voisinage du pied de grille lorsqu'elle est en contact direct avec la couche barrière 13 (zone Z1 s'étendant sur au maximum 100 nm). La deuxième couche de passivation PLlow recouvre le reste de la face 14 (zone Z2) afin de passiver l'intégralité de la face 14.

Ainsi le fait de localiser la première passivation permet de pouvoir utiliser des matériaux à plus forte permittivité relative (matériaux dit High-K) et de considérablement améliorer la tenue en tension sans dégrader les performances RF (on obtient à l'optimum jusqu'à 30-40% de réduction du champ électrique contre au mieux 10% pour le brevet US9099433).

Typiquement la première couche de passivation est en un matériau choisi parmi : Y₂O₃, ZrO₂, HfO₂, Ta₂O₅, TiO₂, La₂O₃, Pr₂O₃, SrTiO₃, BaTiO₃.

Ces matériaux à forte constante diélectrique ne sont pas classiquement utilisés pour la passivation de transistor HEMT haute fréquence : la présence d'une couche diélectrique à forte constante diélectrique au pied de grille est contre intuitive. En effet pour les applications haute fréquence on cherche à réduire le plus possible les capacités Cgs et Cgd donc à utiliser des passivations ayant des constantes diélectriques les plus faibles possible.

Le choix du matériau diélectrique de PLhi dépend des tensions maximales vues par le transistor et de la densité d'électrons ns dans le canal. Ainsi, plus les tensions de fonctionnement et la densité d'électrons dans le canal sont élevées, et plus la constante diélectrique du matériau doit être élevée pour réduire l'intensité du champ électrique dans la barrière et relaxer les contraintes induites par effet piézoélectrique inverse, à l'origine d'une partie des dégradations des composants de puissance.

L'épaisseur de la couche PLhi est délimitée pour sa valeur basse par l'obtention d'un effet sur les champs électriques et pour sa valeur haute par les dégradations qui apparaissent sur les performances RF du transistor. Pour une couche PLhi localisée, la valeur haute critique pour les performances RF est d'autant plus élevée que l'extension de la zone Z1 est faible.

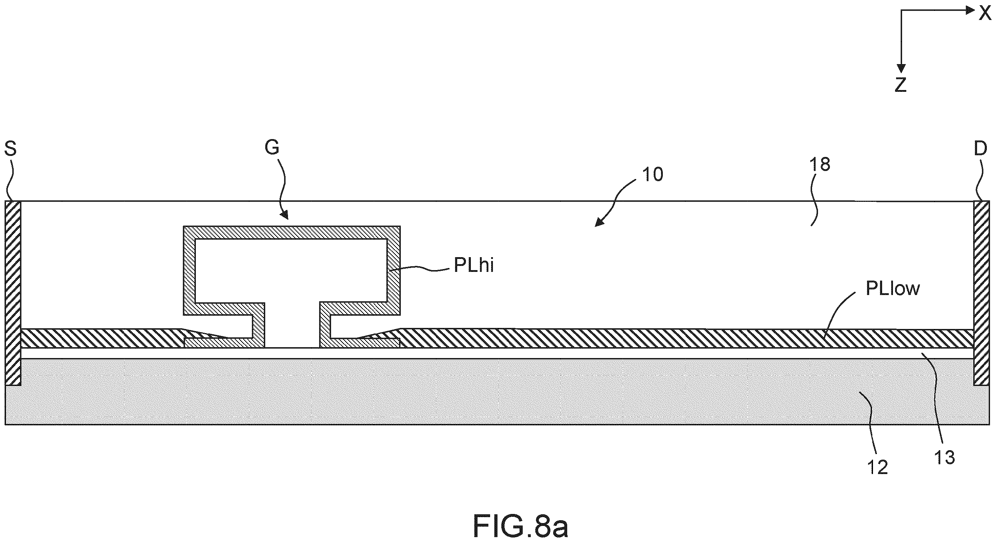

La figure 8a illustre le transistor 10 issu du procédé selon l'invention de la première variante (couche PLhi déposée d'abord) avec l'option d'une couche PLhi qui enrobe toute la grille et qui est déposée en utilisant le chapeau de grille comme masque.

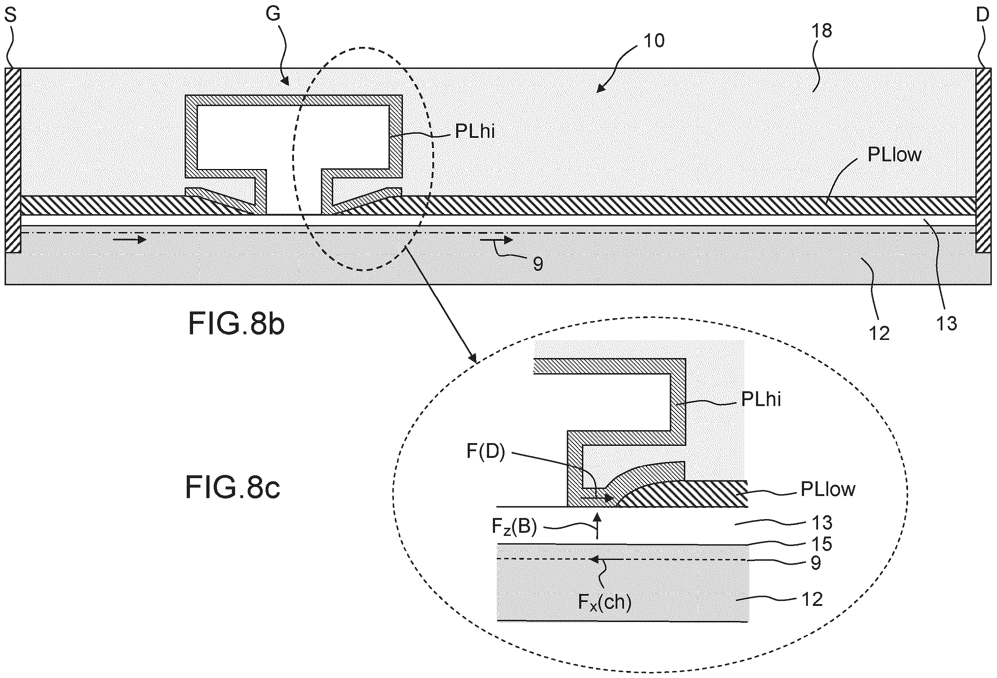

La figure 8b illustre le transistor 10 issu du procédé selon l'invention de la deuxième variante (couche PLlow déposée d'abord) avec l'option d'une couche PLhi qui enrobe toute la grille et qui est déposée en utilisant le chapeau de grille comme masque. La couche PLlow n'est déposée que sur une zone Z2 et laisse une zone Z1 libre de manière à ce que PLhi déposée après soit en contact direct avec la couche barrière 13.

La figure 8c illustre les différents champs électriques d'intérêt au voisinage du pied de grille pour la configuration de la figure 8b: le champ Fz(B) est la projection selon z du champ électrique dans la couche barrière proche de la surface 14; le terme |F(D)| est le module du champ électrique dans la partie de la couche PLhi en contact avec la couche barrière; le champ Fx(ch) est la projection selon x du champ électrique dans le canal 9 localisé dans la couche tampon 12 proche de l'interface 15.

Préférentiellement comme illustré figures 8b et 8c l'espace entre la Source et le Drain est rempli d'un matériau de type BCB pour éviter tout contact avec l'air.

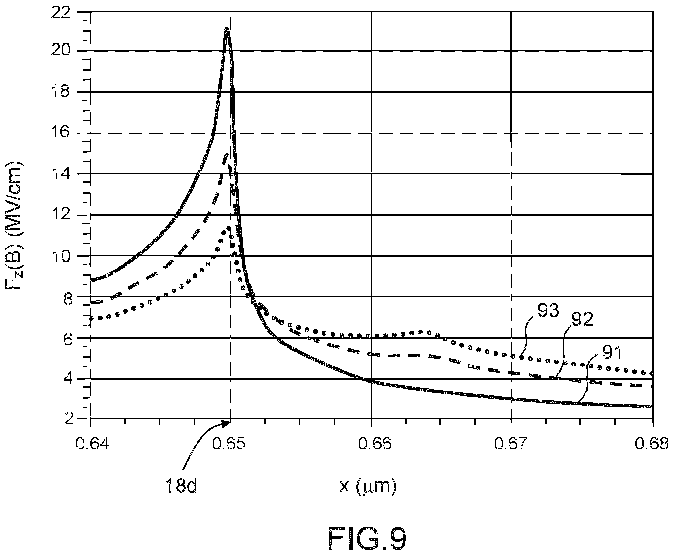

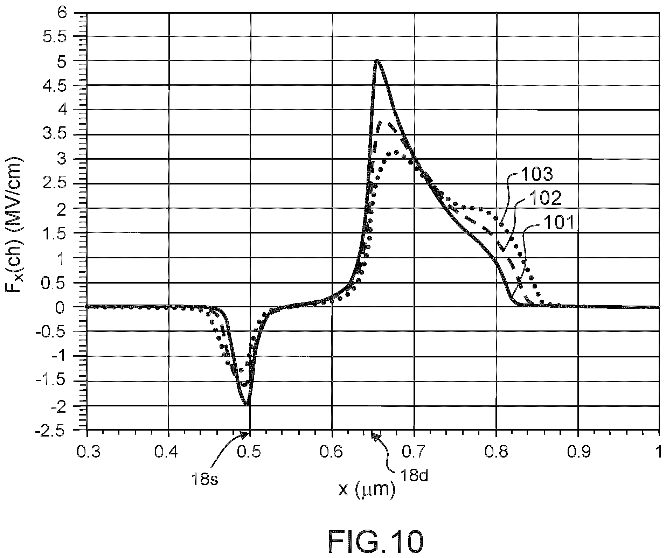

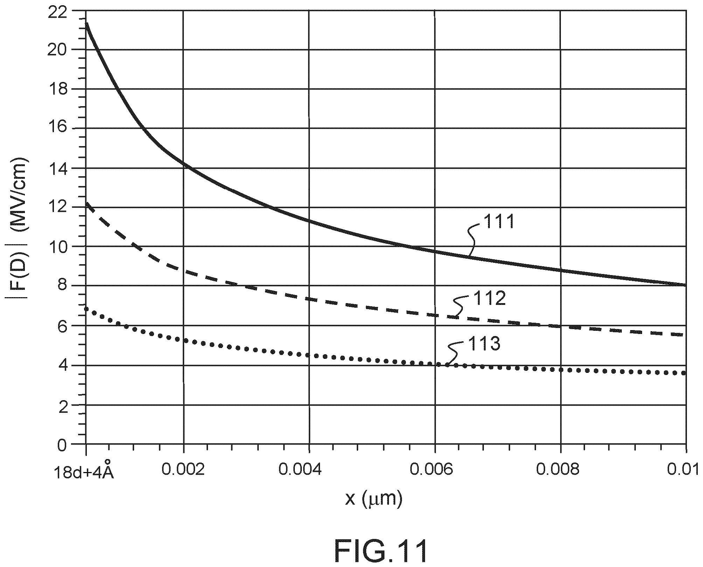

Les figures 9, 10 et 11 illustrent les valeurs respectivement des champs électriques Fz(B), Fx(ch) et |F(D)| (module du champ électrique) en fonction de x (côté drain), la valeur de x correspondant au pied de grille (18s côté source, 18d côté drain) étant indiquée sur les figures. C'est du côté du drain que le champ électrique au pied de la grille est le plus important, le champ côté source est inférieur au champ côté drain. Sur les figures 9 et 10 l'origine des x est la source S, et sur la figure 11 l'origine des x est le pied de grille 18d et le champ électrique est tracé entre 4 angströms et 10nm à compter de cette origine.

Les courbes en traits plein 91, 101, 111 correspondent à une valeur de la constante diélectrique de la première couche de passivation PLhi égale à 7 (cas classique du Si₃N₄), les courbes en pointillés longs 92, 102, 112 à une valeur de εₕᵢ de 15 et les courbes en pointillés 93, 103 et 113 à une valeur de 30 (par exemple le TiO₂ ou le Ta₂O₅).

Les simulations d'un HEMT en GaN selon l'invention pour une structure de type InAIGaN/AIN/GaN des figures 9 à 11 ont été menées à l'aide du logiciel Silvaco, avec :
- une configuration de type de la figure 8a PLhi s'étend selon Z1 et autour de la grille
- d_{GS} = 0.8 µm ; d_{GD} = 1.6 µm ;
- Grille : largeur du tronc 16 : 150 nm ; dimension des branches : 150 nm de chaque côté,
- une densité d'électrons dans le canal ns = 1,6.10¹³/cm², une tension Vds = 40V ; une tension Vgs = -9V (conditions les plus stressantes pour le transistor) ;
- extension de Z1 de 100 nm de chaque côté du pied de grille; une épaisseur de la couche PLhi eₕᵢ = 30 nm ;
- ε_{low} = 7 e_{low} = 30 nm ;

On constate sur ces trois figures une baisse très importante des valeurs des trois champs électriques au voisinage du pied de grille 18d lorsque la valeur de la constante diélectrique de PLhi augmente. Le champ Fz(B) diminue d'une valeur de presque 21 MV/cm pour εₕᵢ=7 à une valeur de 15 MV/cm pour εₕᵢ=15. De même Fx(ch) diminue d'une valeur de 5 MV/cm pour εₕᵢ=7 à une valeur de 3.8 MV/cm pour εₕᵢ=15. Le module de F(D) diminue de presque 21 MV/cm pour εₕᵢ=7 à une valeur de 12 MV/cm pour εₕᵢ=15. Ces valeurs plus faibles des champs électriques de 30 à 40 % rendent le transistor beaucoup moins sensible aux dislocations locales et relaxe les contraintes induites par effet piézoélectrique inverse.

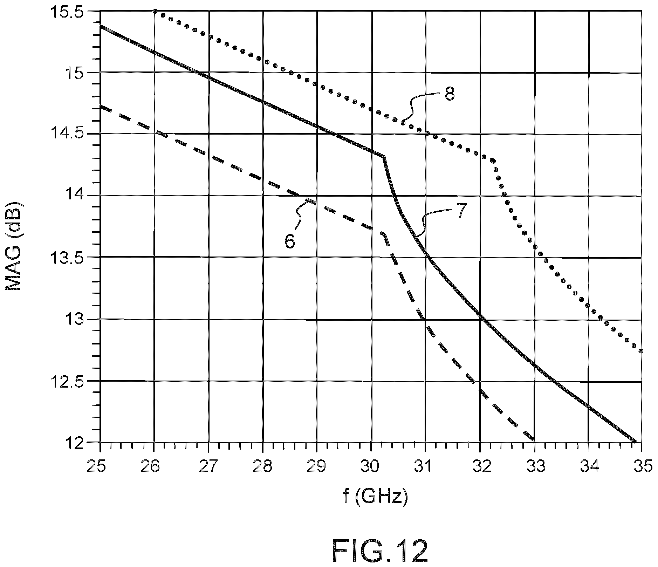

La figure 12 illustre le Gain ou MAG («Max Available Gain ») du transistor selon l'invention en fonction de la fréquence d'utilisation, pour la configuration suivante :
- une configuration de type de la figure 8a PLhi s'étend selon Z1 et autour de la grille
- d_{GS} = 0.8 µm ; d_{GD} = 1.6 µm ;
- Grille : largeur du tronc 16 : 100 nm ; dimension des branches : 150 nm de chaque côté.
- ns = 1,6 10¹³/cm² ; Vds=20V ; Ids = 150 mA/mm (correspond à une situation de fonctionnement en classe AB).

εₕᵢ = 30 et eₕᵢ = 30 nm
ε_{low} = 7 et e_{low} = 30 nm

La courbe 6 illustre le cas pour lequel PLhi s'étend sur toute la surface (ne correspond pas à l'invention), la courbe 7 illustre le cas d'un dépôt de PLhi avec Z1 d'étendue 100 nm de part et d'autre de la grille, et la couche 8 illustre le cas d'un dépôt de PLhi localisé sur 25 nm de part et d'autre de la grille.

On constate avec la courbe 6 (extension de PLhi sur toute la surface) que le gain du transistor est dégradé : l'extension de la zone Z1 est limitée par le maintien d'un gain du transistor acceptable, et une zone Z1 trop étendue n'est pas souhaitable.

Pour 25 nm d'extension (courbe 8) les performances sont meilleures que pour 100 nm (courbe 7), et on considère que 100 nm est donc une borne haute pour l'extension de Z1. Au-delà les pertes sur le gain sont jugées trop importantes. Ainsi la valeur maximale de l'extension de Z1 est donnée par la diminution acceptable des performances sur le gain du transistor.

La valeur minimale de l'extension de Z1 au pied de la grille est celle qui permet l'obtention d'un effet sensible sur la diminution du champ électrique évalué par simulation à 1 nm.

L'invention concerne un procédé de réalisation d'un transistor à effet de champ à haute mobilité comprenant une étape de réalisation d'un empilement 10 selon un axe z déposé sur un substrat, l'empilement comprenant une couche tampon 12, une couche barrière 13, une hétérojonction 15 entre ladite couche tampon 12 et ladite couche barrière 13 et, un gaz bidimensionnel d'électrons 9 tel que décrits précédemment.

Le procédé comprend également une étape de réalisation d'un drain D, d'une source S, et d'une grille G disposée sur la face supérieure 14 de la couche barrière 13 entre la source et le drain, et de sorte que la grille G présente une forme comprenant un tronc 16 surplombé d'au moins un chapeau 17, la base du tronc en contact avec la couche barrière étant dénommée pied de grille, avec 18s correspondant au pied de grille côté source et 18d correspondant au pied de grille côté drain. La face supérieure 14 de la couche barrière entre la source et le drain présente une première zone Z1 localisée à partir du pied de grille et de part et d'autre de la grille sur une distance d'au plus 100 nm, et une deuxième zone Z2 localisée sur la partie restante de la face supérieure.

Le procédé comprend également une étape de dépôt d'une première couche de passivation PLhi présentant une première constante diélectrique supérieure ou égale à 15, le dépôt étant réalisé de sorte que la première couche de passivation s'étende sur au moins la première zone Z1, la première couche de passivation PLhi étant en contact direct avec la couche barrière 13 uniquement sur la première zone Z1.

Le procédé comprend également une étape de dépôt d'une deuxième couche de passivation PLlow présentant une constante diélectrique ε_{low} inférieure ou égale à 10, le dépôt étant réalisé de sorte que la deuxième couche de passivation s'étende sur au moins la deuxième zone Z2, la deuxième couche de passivation étant en contact direct avec la couche barrière 13 uniquement sur la deuxième zone Z2.

Dans le procédé selon l'invention l'étape de dépôt de la première couche de passivation comprend une sous-étape de gravure au travers dudit chapeau de grille, la première couche de passivation (PLhi) étant alors délimitée par la projection selon Z dudit chapeau.

Selon une première variante l'étape de dépôt de la première couche de passivation a lieu avant l'étape de dépôt de la deuxième couche de passivation, la deuxième couche de passivation recouvrant alors au moins partiellement la première couche de passivation.

Selon une deuxième variante l'étape de dépôt de la deuxième couche de passivation a lieu avant l'étape de dépôt de la première couche de passivation, la première couche de passivation couche recouvrant alors partiellement la deuxième couche de passivation.

Selon un mode de réalisation l'étape de dépôt de la première couche de passivation PLhi est réalisée par dépôt atomique à plasma dénommée PE-ALD pour « Plasma Enhanced- Atomic Layer Déposition » en anglais.

Le dépôt par ALD est une technique qui permet de déposer des films ultra-minces de quelques nm d'épaisseur de manière contrôlée. Cette technique offre un excellent contrôle de l'épaisseur et de l'uniformité de la couche déposée et permet également de réaliser des dépôts conformes sur des structures 3D ayant des facteurs de forme élevés. Le plasma permet de réaliser ces dépôts à plus basse température.

Cette première couche peut aussi être réalisée par PECVD (Plasma Enhanced Chemical Vapor Déposition en anglais), PVD (Plasma Vapor Déposition en anglais), ALD (Atomic Layer Déposition en anglais), HWCVD (Hot Wire Chemical Vapor Déposition en anglais), CAT-CVD (catalytic Chemical Vapor Déposition en anglais), ECR-CVD (Electron-Cyclotron Resonance Chemical Vapor Déposition en anglais), ICP-CVD (Inductively Coupled Plasma Chemical Vapor Déposition en anglais), par évaporation, pulvérisation ou toute autre technique de dépôt connue.

Selon un mode de réalisation l'étape de dépôt de la deuxième couche de passivation PLlow est réalisée par ICP CVD (pour « Inductively Coupled Plasma Chemical Vapor Déposition » en anglais.

Cette technique de dépôt permet de réaliser des films diélectriques (typiquement SiO₂, Si₃N₄, SiON) de très bonne qualité, à basse température (dès 5°C) sans endommager la surface sur laquelle ces films sont déposés.

Cette deuxième couche peut aussi être réalisée par LPCVD (Low-Pressure Chemical Vapor Déposition en anglais), PECVD (Plasma Enhanced Chemical Vapor Déposition en anglais), PVD (Plasma Vapor Déposition en anglais), ALD (Atomic Layer Déposition en anglais), PEALD (Plasma Enhanced Atomic Layer Déposition en anglais), ICP-CVD (Inductively Coupled Plasma Chemical Vapor Déposition en anglais), par évaporation, pulvérisation ou toute autre technique de dépôt connue.

## Revendications

1. Procédé de réalisation d'un transistor à effet de champ à haute mobilité comprenant :
- une étape de réalisation d'un empilement (10) selon un axe z déposé sur un substrat (11), l'empilement comprenant :
• une couche tampon (12) comprenant un premier matériau semi-conducteur comprenant un composé binaire ou ternaire ou quaternaire de nitrure et présentant une première bande interdite,
• une couche barrière (13) comprenant un deuxième matériau semi-conducteur comprenant un composé binaire ou ternaire ou quaternaire de nitrure et présentant une deuxième bande interdite, la deuxième bande interdite étant supérieure à la première bande interdite,
• une hétérojonction (15) entre ladite couche tampon (12) et ladite couche barrière (13) et,
• un gaz bidimensionnel d'électrons (9) localisé dans un plan xy perpendiculaire à l'axe z et au voisinage de l'hétérojonction (15), puis
- une étape de réalisation d'un drain (D), d'une source (S), et d'une grille (G) disposée sur une face supérieure (14) de ladite couche barrière (13) entre la source et le drain, et de sorte que la grille (G) présente une forme comprenant un tronc (16) surplombé d'au moins un chapeau (17), une base du tronc en contact avec ladite couche barrière étant dénommée pied de grille (18s, 18d), la face supérieure (14) de la couche barrière entre la source et le drain présentant une première zone (Z1) localisée à partir du pied de grille et de part et d'autre de la grille sur une distance d'au plus 100 nm, et une deuxième zone (Z2) localisée sur la partie restante de la face supérieure,
- une étape de dépôt d'une première couche de passivation (PLhi) présentant une constante diélectrique (εₕᵢ) supérieure ou égale à 15, ledit dépôt étant réalisé de sorte que la première couche de passivation s'étende sur au moins la première zone (Z1), la première couche de passivation (PLhi) étant en contact direct avec la couche barrière (13) uniquement sur la première zone (Z1),
- une étape de dépôt d'une deuxième couche de passivation (PLlow) présentant une constante diélectrique (ε_{low}) inférieure ou égale à 10, ledit dépôt étant réalisé de sorte que la deuxième couche de passivation s'étende sur au moins la deuxième zone (Z2), la deuxième couche de passivation étant en contact direct avec la couche barrière (13) uniquement sur la deuxième zone (Z2),
- l'étape de dépôt de la première couche de passivation comprenant une sous-étape de gravure au travers dudit chapeau de grille, la première couche de passivation (PLhi) étant alors délimitée par la projection selon Z dudit chapeau.

2. Procédé selon la revendication précédente dans lequel l'étape de dépôt de la première couche de passivation a lieu avant l'étape de dépôt de la deuxième couche de passivation, ladite deuxième couche de passivation recouvrant alors au moins partiellement la première couche de passivation.

3. Procédé selon la revendication 1 dans lequel l'étape de dépôt de la deuxième couche de passivation a lieu avant l'étape de dépôt de la première couche de passivation, ladite première couche de passivation recouvrant alors partiellement la deuxième couche de passivation.

4. Procédé selon l'une des revendications précédentes dans lequel l'étape de dépôt de la première couche de passivation (PLhi) est réalisée par dépôt atomique à plasma (PE-ALD).
